# EUROPEAN PATENT SPECIFICATION

(11) **EP 2 660 875 B1**
(45) Date of publication and mention of the grant of the patent: **12.07.2017**
(21) Application number: 11824261.9
(22) Date of filing: 26.12.2011
(51) Int. Cl.: H02S 30/10, H02S 40/30, H02S 20/26

(54) **PHOTOVOLTAIC MODULE FOR CURTAIN WALLS AND A CURTAIN WALL THAT INCLUDES SUCH PHOTOVOLTAIC MODULES**
PHOTOVOLTAISCHES MODUL FÜR STORE UND STORE DIE SOLCHE PHOTOVOLTAISCHE MODULE ENTHÄLT
MODULE PHOTOVOLTAÏQUE POUR MURS RIDEAU ET MUR RIDEAU COMPRENANT LESDITS MODULES PHOTOVOLTAÏQUES

(30) Priority: 27.12.2010 ES 201031960
(43) Date of publication of application: 06.11.2013
(73) Proprietor: FUNDACIÓN TECNALIA RESEARCH & INNOVATION, 20009 San Sebastian (Guipuzcoa) (ES)
(72) Inventor: AMUNDARAIN SUAREZ, Aitor, E-48160 Derio (Vizcaya) (ES); CHICA PÁEZ, José, Antonio, E-48160 Derio (Vizcaya) (ES); CAMPOS DOMINGUEZ, José, María, E-48160 Derio (Vizcaya) (ES); ROMÁN MEDINA, Eduardo, E-48160 Derio (Vizcaya) (ES); ASTUDILLO LARRAZ, Julen, E-48160 Derio (Vizcaya) (ES); MENO IGLESIAS, Sandra, E-48160 Derio (Vizcaya) (ES)
(74) Representative: Carpintero Lopez, Francisco
(86) International application number: PCT/ES2011/070902
(87) International publication number: WO 2012/089883

(56) References cited:
- CN-Y- 201 162 294
- JP-A- 2002 106 131

## Description

### Technical Field of the Invention

The present invention is encompassed within the technical field of curtain walls integrating photovoltaic panels particularly for use in façades.

### Background of the Invention

Due to the important environmental, social and economic impacts associated with the traditional methods of electric generation, there is a growing trend to use more sustainable solutions which reduce said impacts. As a result, renewable electric generation technologies, as is the case of photovoltaic solar energy, are experiencing an important boost.

There are many levels in the implementation of this technology and one of the most appealing is its combination with buildings. This is due to many factors among which the possibility of using the façades of buildings as large generating surfaces should be highlighted. At the same time, the effect of the shade provided by the photovoltaic cells on inner enclosures defined in the building can satisfactorily have a bearing on the reduction of its energy consumption, provided the systems are suitably designed.

Installing photovoltaic panels in façades, the photovoltaic panels being understood as the set made up of laminated glass containing photovoltaic cells, is traditionally done by means of curtain wall systems typically made of aluminum. Systems of this type are generally not designed for housing photovoltaic systems and the sections must be adapted beforehand by means of machining operations which eventually reduce system capabilities.

In addition to these machining operations, the curtain wall systems currently used in building are rather impractical in terms of their on-site assembly due to the fact that modularity concepts in this technology are far from developed. The difficulty in wiring the systems as well as the growing need to provide the installations with power electronic units particular to each photovoltaic panel creates the need to provide solutions in this field.

There are a large number of patents relating to curtain walls but the number of patents with the object of incorporating photovoltaic panels in systems of this type for generating electric energy is scarce.

Patent application US 2008/0163918 A1 provides a solution for facilitating the assembly of photovoltaic panels for use in façades, photovoltaic panels being understood as the set made up of glass, photovoltaic cells, outer buses and connectors. In no case does it solve the subsequent integration thereof in a curtain wall or aluminum frame considering assembly and immediate operation concepts.

Patent application JP 2001015788 relates to the connectivity of photovoltaic panels for creating large, flat photovoltaic surfaces. In said application, solutions for effectively concealing the connection elements are described. It further shows assembly elements for connecting panels, the features and performance of which are limited for use in photovoltaic façades since they have very little insulation capacity.

Patent applications CN 201162294 and CN 101294426 describe semi-structural photovoltaic systems (partially glazed photovoltaic panels with an aluminum subframe) where the structural uprights and crossbeams must be assembled on-site prior to installation. This reduces the versatility and ease of assembly of the system. The same occurs with that described in patent application CN 201176651 where certain removability concepts are shown although without considering possible variations in the position of the connector.

Patent application CN 2938456 does not describe the possible location for a power electronic system of the photovoltaic module. The connection element or connector is positioned in the inner face of the double glazing. The use of quick connect sockets creates problems in assembly due to performance tolerances, possible energy losses due to the deterioration in the connections and increased product cost.

Patent application CN 2527617, in which the connector is inside the sections with the risks of bus corrosion this entails, does not contemplate the location of power electronic elements. The laminating and glazing of the photovoltaic panels follow very specific standards and do not allow flexibility in using different connector types, geometries and location.

### Description of the Invention

The object of the present invention is to overcome the drawbacks of the state of the art detailed above by means of a photovoltaic module comprising at least one photovoltaic panel and a curtain wall containing them, making the installation of energy harnessing systems in building façades by means of photovoltaic cells possible, reducing the problems of on-site assembly, wiring and containment of the power electronic units particular to each photovoltaic module. The final purpose of the invention herein described is to facilitate the design, installation and maintenance of these installations by means of developing connection/disconnection and immediate use (plug-and-play) concepts.

The photovoltaic module according to the present invention comprises
a frame comprising two perimetral half-uprights connected to one another by a first and a second perimetral half-crossbeam and an intermediate crossbeam,
a first double glazing assembled on the intermediate crossbeam and between the perimetral half-uprights and the first perimetral half-crossbeam, and a second double glazing assembled on the second perimetral half-crossbeam and between the intermediate crossbeam and the perimetral half-uprights;
at least one photovoltaic panel in the form of a photovoltaic laminated glass sheet comprised in at least one of the double glazings and in which silicon wafers are embedded;
a power bus connecting said silicon wafers, a connector for facilitating the output of the energy generated in the photovoltaic panel, and a power electronics connected to the power bus;
interconnection means for interconnecting the power electronics of the photovoltaic module with other photovoltaic modules;
characterized in that
the intermediate crossbeam comprises an assembly body in which the double glazings are located, and a longitudinal section attached to the assembly part comprising an axial channel with an axial access opening closed by a removable cover;
the power electronics is housed inside the axial channel of the intermediate crossbeam in a position in which it is accessible through the access opening, and connected to the power bus of the photovoltaic panel by means of a connection cable and the connector.

According to the invention, the axial channel of the longitudinal section can be separated from the assembly part by means of an axial partition wall comprising a through hole through which the respective connection cable passes, preferably through a thimble.

The access opening of the longitudinal section of the intermediate crossbeam can be directed upward or downward, depending on the specific needs of the installation.

According to the invention, both the first and the second double glazing can comprise respective photovoltaic panels in the form of a photovoltaic laminated glass sheet. In this case, a single power electronics can be provided for both photovoltaic panels, or independent electronics can be provided for each of the panels, which would also be arranged in the longitudinal channel of the intermediate crossbeam and respectively connected to each of the connectors of the photovoltaic panels. In the embodiment in which the axial channel of the longitudinal section is separated from the assembly part by means of an axial partition wall, this partition would comprise one or more through holes for the passage of the respective connection cables.

Each of the half-uprights can be provided in the area in which it is coupled to the intermediate crossbeam with a passage opening in which the axial channel of the intermediate crossbeam comes out. The purpose of these passage openings is to allow the passage of one or more interconnect cables interconnecting the power electronics of the module with one or more power electronics of one or more adjacent modules.

Each half-upright can also be provided with housing means for housing at least one axial connection joint which serves to couple the half-upright to a neighboring half-upright of an adjacent photovoltaic module. Thus in one embodiment, each half-upright comprises a U-shaped section with a first wall and a second wall with respective free ends laterally emerging from the photovoltaic module, and an assembly body in which the double glazing is located, the free ends of the walls comprising respective housing grooves for housing respective axial connection joints, such that these joints, inserted under pressure into their respective housings, allow coupling the half-upright of one module to another adjacent one.

On the other hand, each perimetral half-crossbeam can be provided with housing means for housing at least one axial connection joint which serves to couple the perimetral half-crossbeam to a neighboring perimetral half-crossbeam of a photovoltaic module placed above it. In one embodiment, each perimetral half-crossbeam can comprise a U-shaped section with a first wall and a second wall with respective free ends vertically emerging from the photovoltaic module, and an assembly body in which the double glazing is assembled, the free ends of the walls comprising respective housing grooves for housing respective axial connection joints, such that these joints, inserted under pressure into their respective housings, allow coupling the perimetral half-crossbeam of one module to another adjacent one.

The curtain wall for façades according to the invention comprises a plurality of photovoltaic modules, at least one of which, and preferably all of them, are photovoltaic modules such as those previously defined coupled to one another. The coupling and interconnection of the photovoltaic modules to one another using this system to form curtain walls for façades is simple and is carried out successively by means of the initial anchoring of a module to which the adjacent module is joined and so on and so forth until completing the installation of the first floor of the building. The second floor would then be installed and so on and so forth until completing the entire building. Once the modules have been positioned and anchored to the structure of the building, the removable cover must be removed from each of them to facilitate placing the interconnect cables between modules.

### Brief Description of the Drawings

Aspects and embodiments of the invention are described below based on drawings in which
Figure 1 schematically shows a photovoltaic installation incorporating an embodiment of the photovoltaic modules according to the invention;
Figure 2 is a schematic cross-section view of an embodiment of two half-uprights of two contiguous modules present in each of the modules shown in Figure 1;
Figure 3 is a schematic vertical section view of an embodiment of a perimetral half-crossbeam present in each of the modules shown in Figure 1;
Figure 4 is a schematic vertical section view of an embodiment of an intermediate crossbeam present in each of the modules shown in Figure 1.

Reference numbers identifying the following elements are seen in these figures:
- 1: Silicon wafers
- 2: Power buses
- 3: Connector
- 3a: Connection cable
- 4: Pressure clamps
- 5, 5': Double glazing or panel
- 5a, 5a': Photovoltaic panel in the form of a photovoltaic laminated glass sheet
- 5b, 5b': Laminated glass sheet
- 6: Connector chamber
- 7: Compressible rubbers
- 8: Perimetral half-upright joints
- 9: Perimetral half-crossbeam joints
- 10: Thermal bridge breaks
- 11: Shims
- 12: Power electronics
- 13: Removable cover
- 14: Interconnect cables between modules
- 15,15': Half-upright
- 15a: First wall of the half-upright
- 15b: Housing groove
- 15c: Second wall of the half-upright
- 15d: Housing groove
- 15e: Stiffening bridge
- 15f: Glass fastening rubber
- 15g: Spacer of the double glazing
- 15h: Glass fastening rubber
- 15i: Structural outer fixing element
- 16,16': Perimetral half-crossbeam
- 16a: First wall of the half-crossbeam
- 16b: Housing groove
- 16c: Second wall of the half-crossbeam
- 16d: Housing groove
- 16e: Stiffening bridge
- 16f: Glass fastening rubber
- 16g: Spacer of the double glazing
- 16h: Glass fastening rubber
- 16i: Structural outer fixing element
- 17: Intermediate crossbeam
- 17a: Longitudinal section
- 17b: Axial channel
- 17c: Access opening
- 17d: Partition wall
- 17e: Through hole
- 17f: Glass fastening rubber
- 17g: Spacer of the double glazing
- 17h: Glass fastening rubber
- 17i: Structural outer fixing element
- 18: Thimble

### Embodiments of the Invention

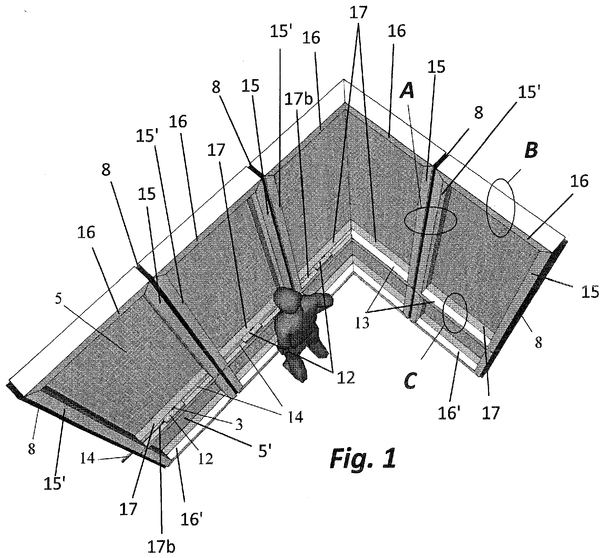

The photovoltaic installation shown in Figure 1 comprises a plurality of photovoltaic modules, each comprising a frame made up of two vertical half-uprights -15, 15'- attached by a first upper half-crossbeam -16-, a second lower half-crossbeam -16'-, and an intermediate crossbeam -17-. A first double glazing -5- is assembled on the intermediate crossbeam -17- and between the perimetral half-uprights -15, 15'- and the first perimetral half-crossbeam -16-, and a second double glazing -5'- is assembled on the second perimetral half-crossbeam -16'- and between the intermediate crossbeam -17- and the perimetral half-uprights -15, 15'-.

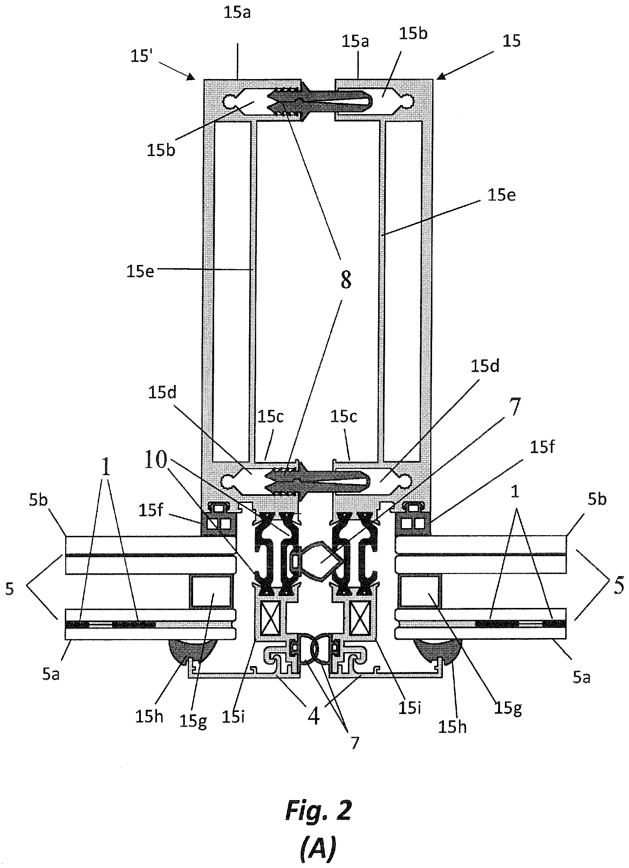

As can be seen in Figures 2 to 4, each double glazing -5, 5'- can comprise a photovoltaic panel in the form of a photovoltaic laminated glass sheet -5a, 5a'- in which photovoltaic cells in the form of a silicon wafer -1- are embedded, the photovoltaic cells being interconnected to one another and jointly connected to a power bus -2-, and a laminated glass sheet-5b, 5b'-, such that the double glazing -5, 5'- is capable of providing thermal and acoustic insulation. This allows the set to meet the requirements established by the building regulations applicable to each situation.

Each intermediate crossbeam -17- comprises a section with an axial channel -17b- in which there is arranged a power module -12- connected to the power bus -2-by means of a connector -3- and its respective connection cable -3a-. The power modules -12- are connected to one another by means of respective interconnect cables -14- which also extend in the respective axial channels -17b- and which pass through respective thimbles -18- arranged in respective passages made in the half-uprights -15, 15'-. The axial channel -17b- of the intermediate crossbeam -17- of each module can be covered by a detachable or removable cover -13-.

The half-uprights -15, 15'- are provided with vertical joints -8- allowing the assembly and a proper attachment of the adjacent photovoltaic modules. As shown in Figure 2, each half-upright comprises a U-shaped section with a first wall -15a- and a second wall -15c- with respective housing grooves -15b, 15d- in which there are housed under pressure respective vertical joints -8- whereby the half-uprights -15, 15'- of two adjacent photovoltaic modules are coupled. The walls -15a, 15c- are connected to one another by an axial stiffening bridge -15e-.

Each half-upright -15, 15'- further comprises, coupled to its second wall -15c-, an assembly body in which the corresponding double glazing -5, 5'- is located. This assembly body comprises a structural assembly element -15i- in the form of a longitudinal section made from a rigid material, such as aluminum for example, coupled to the outer face of the second wall -15c- of the half-upright -15, 15'-through semi-rigid elements acting as a thermal bridge break -10-, the end edges of which are fixed under pressure in respective first longitudinal grooves in a first side area of the outer face of the second wall -15c- and in respective longitudinal grooves in the face of the structural assembly element -15i- facing said outer face. In a second side area, the outer face of the second wall -15c- comprises a second longitudinal groove in which a glass fastening rubber -15f- is fixed. A longitudinal spacer -15g- is arranged between the laminated glass sheet -5a- and the photovoltaic laminated glass sheet -5b-. The structural outer fixing element -15i- is coupled on its outer side to a first longitudinal rolled edge of a pressure clamp -4-. On the other hand, the assembly body has a longitudinal compressible rubber -7- on its side facing the assembly body of a neighboring half-upright. The second rolled edge of the pressure clamp -4- is coupled to another longitudinal glass fastening rubber -15h- pressing on the outer face of the photovoltaic laminated glass sheet-5a-.

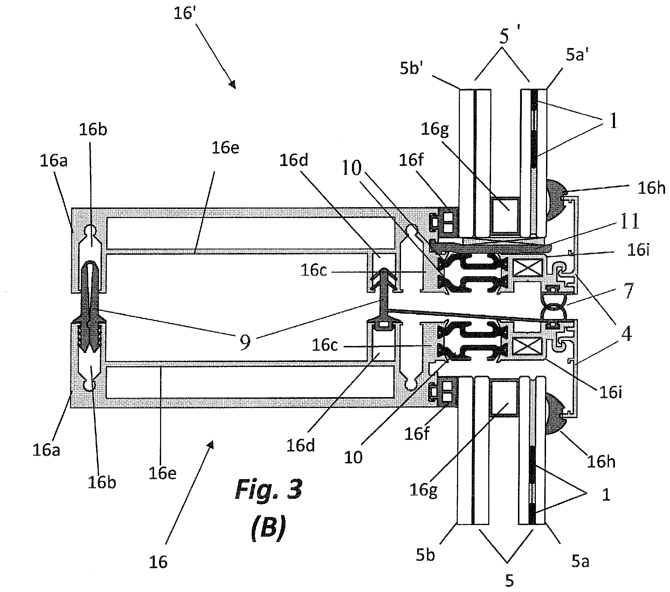

As shown in Figure 3, the perimetral half-crossbeams -16, 16'- are in turn provided with horizontal joints -9- which allow properly assembling and attaching photovoltaic modules arranged on top of one another. Each half-crossbeam -16, 16'-comprises a U-shaped section with a first wall -16a- and a second wall -16c- with respective housing recesses -16b, 16d- in which there are housed under pressure respective vertical joints -9- whereby the half-crossbeams -16, 16'- of one photovoltaic module arranged on top of another are coupled. The walls -16a, 16care connected to one another by an axial stiffening bridge -16e-. Each perimetral half-crossbeam -16, 16'- further comprises, coupled to its second wall -16c-, an assembly body in which the corresponding double glazing -5, 5'- is located. This assembly body comprises a structural assembly element -16i- in the form of a longitudinal section made from a rigid material, such as aluminum for example, coupled to the outer face of the second wall -16c- of the half-crossbeam -16, 16'-through semi-rigid elements which act as a thermal bridge break -10-, the end edges of which are fixed under pressure in respective first longitudinal grooves in a first side area of the outer face of the second wall -16c- and in respective longitudinal grooves in the face of the structural assembly element -16i- facing said outer face. In a second side area, the outer face of the second wall -16c- comprises a second longitudinal groove in which a glass fastening rubber -16f- is fixed. A longitudinal spacer -16g- is arranged between the laminated glass sheet-5a, 5a'- and the photovoltaic laminated glass sheet-5b, 5b'-. The structural outer fixing element -16i-is coupled on its outer side to a first longitudinal rolled edge of a pressure clamp -4-. On the other hand, the assembly body -16, 16'- has a longitudinal compressible rubber -7- on its side facing the assembly body of a neighboring half-crossbeam. The second rolled edge of the pressure clamp -4- is coupled to another longitudinal glass fastening rubber -16h- pressing on the outer face of the photovoltaic laminated glass sheet-5a, 5a'-. The sheets -5a', 5b' making up the second double glazing -5'-rest on a shim -11- placed between the edges of said sheets and the structural assembly element -16i-.

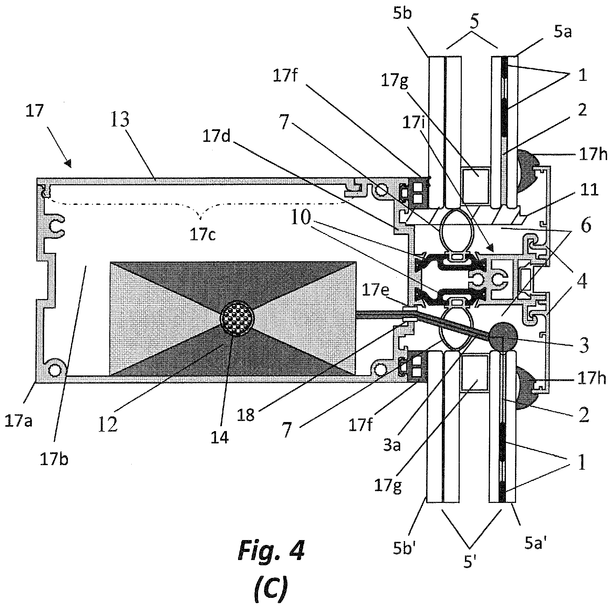

As can be seen in Figure 4, each of the intermediate crossbeams -17-comprises a U-shaped longitudinal section -17a- and an assembly body on which the first double glazing -5- is assembled and the corresponding second double glazing-5'- is located. The power electronics -12- is housed inside the axial channel -17b- of the intermediate crossbeam -17- in a position in which it is accessible through an access opening -17c- and is connected though a connection cable -3a- to a connector -3- which in turn is connected to the power bus -2- embedded in the photovoltaic laminated glass sheet-5a, 5a'-. The longitudinal section -17- comprises a partition wall -17d- comprising a through hole -17e- through which the respective connection cable -3a- of the connector -3- connected to the second photovoltaic laminated glass sheet-5a'- passes through a thimble -18-.

Although the intermediate crossbeam is placed with the access opening -17c- of its longitudinal section -17a- directed upward in the embodiment shown in Figure 4, it is also possible to place it such that the access opening is directed downward, depending on the specific needs of the installation.

Although it is not shown in Figure 4, the power electronics can also be connected to the first photovoltaic laminated glass sheet-5a-, or an additional power electronics can be provided for this first photovoltaic laminated glass sheet-5a-, also housed inside the axial channel -17b- of the intermediate crossbeam -17- in a position in which it is also accessible through the access opening -17c-. Whether it is the power electronics itself which is connected to the second photovoltaic laminated glass sheet -5a'- or whether the power electronics for the first photovoltaic laminated glass sheet-5a- is an additional unit, the first photovoltaic laminated glass sheet-5a- is connected to such power electronics by means of a connection similar to that of the second photovoltaic laminated glass sheet-5a'-, i.e., by means of an additional connection cable connected to an additional connector which in turn is connected to the power bus of the first photovoltaic laminated glass sheet-5a'-. Said additional cable passes through an additional passage opening in the partition wall of the longitudinal section -17a-. The inner space of the intermediate crossbeam -17-, i.e., the axial channel -17b-, is thus connected to the half-uprights and allows complete and simple wiring of the installation. This space can also be used for the passage of other installations.

The assembly body of each intermediate crossbeam -17- is coupled to the partition wall -17d- of the longitudinal section -17a- and comprises two connector chambers -6-, one, as shown in Figure 4, for the connector -3- of the second photovoltaic laminated glass sheet-5a'-, and the other for the additional connector (not shown in Figure 4) of the additional connector of the first photovoltaic laminated glass sheet-5a-.

The assembly body further comprises a structural assembly element -17i- in the form of a longitudinal section made from a rigid material, such as aluminum for example, coupled to a central part of the outer face of the second wall -17d- of the intermediate crossbeam -17- through semi-rigid elements which act as a thermal bridge break -10-, the end edges of which are fixed under pressure in respective first longitudinal grooves in the central area of the outer face of the second wall -17d- and in respective longitudinal grooves in the face of the structural assembly element -17i- facing said outer face. In its respective side areas, the outer face of the second wall -17d- comprises respective longitudinal side grooves in which respective glass fastening rubbers -17f- are fixed. A longitudinal spacer -17g- is arranged between the laminated glass sheet-5a, 5a'- and the photovoltaic laminated glass sheet-5b, 5b'-. The structural outer fixing element -16i- is coupled on its outer side to the first longitudinal rolled edges of respective pressure clamps -4-. The second rolled edge of each pressure clamp -4- is coupled to another longitudinal glass fastening rubber -17h- pressing on the outer face of the photovoltaic laminated glass sheet-5a, 5a'-. The sheets -5a, 5b- making up the first double glazing -5- rest on a shim -11- placed between the edges of said sheets and the structural assembly element -17i-.

The location of the connector -3- in the upper area of the second photovoltaic laminated glass sheet-5a'- and of the additional connector in the lower area of the first photovoltaic laminated glass sheet-5a- means that the assembly part must have a geometry which allows positioning these connectors, providing sufficient clearance to facilitate the assembly thereof. Therefore, the connector chambers -6- are designed to allow housing connectors with variable dimensions.

The fact that the chambers -6-, the connectors -3- and the photovoltaic laminated sheet glasses -5a, 5a'- are located behind the respective pressure clamps -4- makes it possible in the assembled system to access each of the connectors -3- and buses -2- by removing the corresponding pressure clamp -4-, allowing the maintenance, inspection and repair thereof in the event of operating irregularities.

The dimensions of the connector chambers -6- give rise to the occurrence of air volumes inside the assembly body, which are unacceptable from the thermal point of view due to the occurrence of convection flows favoring heat losses. Due to this circumstance, the set of compressible rubbers -7- favors the minimization of such flows, and better thermal behavior of the system and a reduction in its thermal transmittance therefore takes place.

The half-uprights -15, 15'-, half-crossbeams -16, 16'- and the intermediate crossbeam -17- housing the double glazing -5, 5'- can be previously assembled on-site without the glass or be factory assembled together with the glass and positioned on the anchors already fixed to the slabs of the building. This second industrialized option is more appealing because it provides rapid assembly, safety and more effective quality control. On the other hand, the possibility of positioning modules that are completely glazed and already equipped with photovoltaics is very appealing from the technological point of view and facilitates carrying out installations of this type.

The way to adapt the system to any double glazing width is by means of the thermal bridge breaks -10-, the dimensions of which can vary for being adjusted to the necessary width. The thermal and acoustic characteristics of the set can thus be adjusted to specific designer requirements.

The shims -11- in those crossbeams and half-crossbeams having a structural bearing facilitate positioning the double glazings -5, 5'-.

As expressed above, a system of pressure clamps -4- allows maintaining and disassembling those deteriorated panels. These elements are capable of concealing both the connector -3- and the perimetral buses -2- for protecting them against weather effects and for esthetic reasons.

The interconnection of photovoltaic modules using the system described above to form a curtain wall is simple and is successively carried out by means of the initial anchoring of a module to which the adjacent module is joined and so on and so forth until completing the installation of the first floor of the building. The second floor would then be installed and so on and so forth until completing the entire building. Once the modules have been positioned and anchored to the structure of the building, the removable cover -13- must be removed from each of them to facilitate placing the interconnect cables -14- between modules.

These interconnect cables -14- couple the power electronics -12- located in each of the modules allowing serial and parallel connections according to system requirements. The interconnect cables -14- end in a current transformer element known as an inverter (not shown in the drawings).

## Claims

1. Photovoltaic module comprising
a frame (15, 15', 16, 16', 17) comprising two perimetral half-uprights (15, 15') connected to one another by a first and a second perimetral half-crossbeam (16, 16') and an intermediate crossbeam (17),
a first photovoltaic double glazing (5) assembled on the intermediate crossbeam (17) and between the perimetral half-uprights (15, 15') and the first perimetral half-crossbeam (16), and a second photovoltaic double glazing (5') assembled on the second perimetral half-crossbeam (16') and between the intermediate crossbeam (17) and the perimetral half-uprights (15, 15'); at least one of the double glazings (5, 5') comprising a photovoltaic panel in the form of a photovoltaic laminated glass sheet (5a, 5a') in which silicon wafers are embedded (1) and a power bus (2) connecting said silicon wafers (1);
a power electronics (12) connected to the power bus (2);
interconnection means (14) for interconnecting the power electronics (12) of the photovoltaic module with other photovoltaic modules;
**characterized in that**
the intermediate crossbeam (17) comprises an assembly body in which the double glazings (5, 5') are located, and a longitudinal section (17a) attached to the assembly part comprising an axial channel (17b) with an axial access opening (17c) closed by a removable cover (13);
the power electronics (12) is housed inside the axial channel (17b) of the intermediate crossbeam (17) in a position in which it is accessible thorough the access opening (17c), and connected to a connection cable (3a) of a connector (3) connected to the power bus (2) embedded in the photovoltaic laminated glass sheet (5a, 5a').

2. Photovoltaic module according to claim 1, **characterized in that** the axial channel (17b) of the longitudinal section (17a) is separated from the assembly body by means of an axial partition wall (17d) comprising a through hole (17e) through which the respective connection cable (3a) passes.

3. Photovoltaic module according to claim 1 or 2, **characterized in that** each of the half-uprights (15, 15') has in the area in which it is coupled to the intermediate crossbeam (17) at least one passage opening in which the axial channel (17b) of the intermediate crossbeam (17) comes out, generating a channeling and through which the photovoltaic installation is wired in addition to allowing the housing of additional elements of the photovoltaic system.

4. Photovoltaic module according to claim 1, 2 or 3, **characterized in that** each half-upright (15, 15') comprises housing means (15b, 15d) for housing at least one axial connection joint (8) which serves to couple the half-upright (15) to a neighboring half-upright of an adjacent photovoltaic module.

5. Photovoltaic module according to claim 4, **characterized in that** each half-upright comprises a U-shaped section with a first wall (15a) and a second wall (15c) with respective free ends laterally emerging from the photovoltaic module, and an assembly body in which the double glazing (5, 5') is assembled, and **in that** the free ends of said walls (15a, 15c) comprise respective housing grooves (15b, 15d) for housing respective axial connection joints (8).

6. Photovoltaic module according to one of the preceding claims, **characterized in that** each perimetral half-crossbeam (16, 16') comprises housing means (16b, 16d) for housing at least one axial connection joint (9) which serves to couple the perimetral half-crossbeam (16) to a neighboring perimetral half-crossbeam (16') of a photovoltaic module placed above it.

7. Photovoltaic module according to claim 6, **characterized in that** each perimetral half-crossbeam (16, 16') comprises a U-shaped section with a first wall (16a) and a second wall (16c) with respective free ends vertically emerging from the photovoltaic module, and an assembly body in which the double glazing (5, 5') is assembled, and **in that** the free ends of said walls (16a, 16c) comprise respective housing grooves (16b, 16d) for housing respective axial connection joints (9).

8. Curtain wall for facades comprising a plurality of photovoltaic modules, **characterized in that** it comprises at least one photovoltaic module such as that defined in any one of claims 1 to 7.

## Patentansprüche

1. Photovoltaikmodul, das umfasst
einen Rahmen (15,15',16,16',17), der zwei Umfangs-Halbständer (15, 15') umfasst, die durch eine erste und eine zweite Umfangs-Halbquerstrebe (16, 16') und eine Zwischenquerstrebe (17) miteinander verbunden sind,
eine erste photovoltaische Doppelverglasung (5), die an der Zwischenquerstrebe (17) und zwischen den Umfangs-Halbständern (15, 15') und der ersten Umfangs-Halbquerstrebe (16) montiert ist, und eine zweite photovoltaische Doppelverglasung (5'), die an der zweiten Umfangs-Halbquerstrebe (16') und zwischen der Zwischenquerstrebe (17) und den Umfangs-Halbständern (15, 15') montiert ist; wobei mindestens eine der Doppelverglasungen (5, 5') eine Photovoltaiktafel in der Form einer photovoltaischen beschichteten Glasscheibe (5a, 5a') umfasst, in welche Siliziumwaver (1) und ein Leistungsbus (2), der die Siliziumwaver (1) verbindet, eingebettet sind;
eine mit dem Leistungsbus (2) verbundene Leistungselektronik (12); Verbindungsmittel (14) zum Verbinden der Leistungselektronik (12) des Photovoltaikmoduls mit anderen Photovoltaikmodulen;
**dadurch gekennzeichnet, dass**
die Zwischenquerstrebe (17) einen Baugruppenkörper umfasst, in dem die Doppelverglasungen (5, 5') angeordnet sind, und ein Längsabschnitt (17a), der an dem Baugruppenteil angebracht ist, einen axialen Kanal (17b) mit einer axialen Zugangsöffnung (17c) umfasst, die durch eine entfernbare Abdeckung (13) verschlossen ist;
die Leistungselektronik (12) innerhalb des axialen Kanals (17b) der Zwischenquerstrebe (17) in einer Position untergebracht ist, in welche sie durch die Zugangsöffnung (17c) zugänglich ist, und mit einem Verbindungskabel (3a) eines Verbinders (3) verbunden ist, der mit dem Leistungsbus (2) verbunden ist, der in die photovoltaische beschichtete Glasscheibe (5a, 5a') eingebettet ist.

2. Photovoltaikmodul nach Anspruch 1,
**dadurch gekennzeichnet, dass** der axiale Kanal (17b) des Längsabschnitts (17a) von dem Baugruppenkörper mit Hilfe einer axialen Trennwand (17d) getrennt ist, die ein Durchgangsloch (17e) umfasst, durch welches das jeweilige Verbindungskabel (3a) hindurch verläuft.

3. Photovoltaikmodul nach Anspruch 1 oder 2,
**dadurch gekennzeichnet, dass** jeder der Halbständer (15, 15') in dem Bereich, in welchem er mit der Zwischenquerstrebe (17) gekoppelt ist, mindestens eine Durchgangsöffnung aufweist, in welcher der axiale Kanal (17b) der Zwischenquerstrebe (17) mündet, wodurch eine Kanalverbindung erzeugt wird und durch welche hindurch die Photovoltaikinstallation zusätzlich dazu, dass das Unterbringen zusätzlicher Elemente des Photovoltaiksystems ermöglicht wird, verdrahtet wird.

4. Photovoltaikmodul nach Anspruch 1, 2 oder 3,
**dadurch gekennzeichnet, dass** jeder Halbständer (15, 15') Gehäusemittel (15b, 15d) zum Unterbringen mindestens eines axialen Verbindungsgelenks (8) umfasst, welches zum Koppeln des Halbständers (15) mit einem benachbarten Halbständer eines benachbarten Photovoltaikmoduls dient.

5. Photovoltaikmodul nach Anspruch 4,
**dadurch gekennzeichnet, dass** jeder Halbständer einen U-förmigen Abschnitt mit einer ersten Wand (15a) und einer zweiten Wand (15c) mit jeweiligen freien Enden, die seitlich aus dem Photovoltaikmodul hervorstehen, und einen Baugruppenkörper umfasst, in welchem die Doppelverglasung (5, 5') montiert ist, und dadurch, dass die freien Enden der Wände (15a, 15c) jeweilige Gehäuserillen (15b, 15d) zum Unterbringen jeweiliger axialer Verbindungsgelenke (8) umfassen.

6. Photovoltaikmodul nach einem der vorstehenden Ansprüche,
**dadurch gekennzeichnet, dass** jede Umfangs-Halbquerstrebe (16, 16') Gehäusemittel (16b, 16d) zum Unterbringen mindestens eines axialen Verbindunggelenks (9) umfasst, welches zum Koppeln der Umfangs-Halbquerstrebe (16) mit einer benachbarten Umfangs-Halbquerstrebe (16') eines Photovoltaikmoduls dient, das darüber platziert ist.

7. Photovoltaikmodul nach Anspruch 6,
**dadurch gekennzeichnet, dass** jede Umfangs-Halbquerstrebe (16, 16') einen U-förmigen Abschnitt mit einer ersten Wand (16a) und einer zweiten Wand (16c) mit jeweiligen freien Enden, die aus dem Photovoltaikmodul vertikal hervorstehen, und einen Baugruppenkörper umfasst, in welchem die Doppelverglasung (5, 5') montiert ist, und dadurch, dass die freien Enden der Wände (16a, 16c) jeweilige Gehäuserillen (16b, 16d) zum Unterbringen jeweiliger axialer Verbindungsgelenke (9) umfassen.

8. Vorhangwand für Fassaden, die eine Vielzahl von Photovoltaikmodulen umfasst, **dadurch gekennzeichnet, dass** sie mindestens ein Photovoltaikmodul wie etwa diejenigen, die in einem beliebigen der Ansprüche 1 bis 7 definiert sind, umfasst.

## Revendications

1. Module photovoltaïque qui comprend
une armature (15, 15', 16, 16', 17) qui comprend deux demi-montants périphériques (15, 15') reliés l'un à l'autre par une première et une seconde demi-traverses périphériques (16, 16') et une traverse intermédiaire (17),
un premier double vitrage photovoltaïque (5) assemblé sur la traverse intermédiaire (17) et entre les demi-montants périphériques (15, 15') et la première demi-traverse périphérique (16), et un second double vitrage photovoltaïque (5') assemblé sur la seconde demi-traverse périphérique (16') et entre la traverse intermédiaire (17) et les demi-montants périphériques (15, 15'); au moins l'un des doubles vitrages (5, 5') comprenant un panneau photovoltaïque sous la forme d'une feuille de verre stratifiée photovoltaïque (5a, 5a') à laquelle des tranches de silicium sont intégrées (1) et un bus d'alimentation (2) qui relie lesdites tranches de silicium (1) ;
une électronique de puissance (12) reliée au bus d'alimentation (2) ; un moyen d'interconnexion (14) destiné à interconnecter l'électronique de puissance (12) du module photovoltaïque avec d'autres modules photovoltaïques ;
**caractérisé en ce que**
la traverse intermédiaire (17) comprend un corps d'assemblage dans lequel les doubles vitrages (5, 5') se trouvent, et une section longitudinale (17a) reliée à la partie d'assemblage qui comprend un canal axial (17b) avec une ouverture d'accès axiale (17c) fermée par un capot amovible (13) ;
l'électronique de puissance (12) est située à l'intérieur du canal axial (17b) de la traverse intermédiaire (17) à un emplacement auquel elle est accessible par le biais de l'ouverture d'accès (17c), et est reliée à un câble de connexion (3a) d'un connecteur (3) relié au bus d'alimentation (2) intégré à la feuille de verre stratifiée photovoltaïque (5a, 5a').

2. Module photovoltaïque selon la revendication 1, **caractérisé en ce que** le canal axial (17b) de la section longitudinale (17a) est séparé du corps d'assemblage à l'aide d'une paroi de séparation axiale (17d) qui comprend un orifice traversant (17e) par lequel le câble de connexion respectif (3a) passe.

3. Module photovoltaïque selon la revendication 1 ou 2, **caractérisé en ce que** chacun des demi-montants (15, 15') possède, dans la zone dans laquelle il est relié à la traverse intermédiaire (17), au moins une ouverture de passage dans laquelle le canal axial (17b) de la traverse intermédiaire (17) sort, en générant un effet de canal, et par laquelle l'installation photovoltaïque est reliée, en plus de contenir des éléments supplémentaires du système photovoltaïque.

4. Module photovoltaïque selon la revendication 1, 2 ou 3, **caractérisé en ce que** chaque demi-montant (15, 15') comprend un moyen de logement (15b, 15d) destiné à contenir au moins une jonction axiale (8) qui sert à relier le demi-montant (15) à un demi-montant voisin d'un module photovoltaïque adjacent.

5. Module photovoltaïque selon la revendication 4, **caractérisé en ce que** chaque demi-montant comprend une section en forme de U avec une première paroi (15a) et une seconde paroi (15c) munies d'extrémités libres respectives qui émergent latéralement du module photovoltaïque, et un corps d'assemblage dans laquelle le double vitrage (5, 5') est assemblé, et **en ce que** les extrémités libres desdites parois (15a, 15c) comprennent des rainures de logement respectives (15b, 15d) destinées à contenir les jonctions axiales respectives (8).

6. Module photovoltaïque selon l'une des revendications précédentes, **caractérisé en ce que** chaque demi-traverse périphérique (16, 16') comprend des moyens de logement (16b, 16d) destinés à contenir au moins une jonction axiale (9) qui sert à relier la demi-traverse périphérique (16) à une demi-traverse périphérique voisine (16') d'un module photovoltaïque placé au-dessus de celle-ci.

7. Module photovoltaïque selon la revendication 6, **caractérisé en ce que** chaque demi-traverse périphérique (16, 16') comprend une section en forme de U avec une première paroi (16a) et une seconde paroi (16c) avec des extrémités libres respectives qui émergent verticalement du module photovoltaïque, et un corps d'assemblage dans lequel le double vitrage (5, 5') est assemblé, et **en ce que** les extrémités libres desdites parois (16a, 16c) comprennent des rainures de logement respectives (16b, 16d) destinées à contenir les jonctions axiales respectives (9).

8. Mur-rideau destiné à des façades qui comprennent une pluralité de modules photovoltaïques, **caractérisé en ce qu'**il comprend au moins un module photovoltaïque tel que celui défini dans l'une quelconque des revendications 1 à 7.
